# EUROPEAN PATENT APPLICATION

(11) **EP 2 278 590 A2**
(43) Date of publication of application: **26.01.2011**
(21) Application number: 08022019.7
(22) Date of filing: 18.12.2008
(51) Int. Cl.: G11C 16/02

(54) **Integrated circuit including memory having limited read**

(30) Priority: 05.02.2008 US 026249
(71) Applicant: Qimonda AG, 81739 München (DE)
(72) Inventor: Happ, Thomas, 01109 Dresden (DE); De Ambroggi, Luca, 81667 München (DE); Kreupl, Franz, 80802 München (DE); Schrögmeier, Peter, 81547 München (DE); Steinlesberger, Gernot, 83624 Otterfing (DE); Pho-Duc, Cristian, 85635 Höhenkirchen-Siegertsbrunn (DE); Philipp, Jan Boris, 81673 München (DE)

(57) **Abstract**

An integrated circuit including a memory with an array of memory cells, each memory cell comprising a non-volatile memory element; and a limited read circuit communicatively coupled to the array of memory cells.

## Description

### Background

One type of memory is resistive memory. Resistive memory utilizes the resistance value of a memory element to store one or more bits of data. For example, a memory element programmed to have a high resistance value may represent a logic "1" data bit value and a memory element programmed to have a low resistance value may represent a logic "0" data bit value. Typically, the resistance value of the memory element is switched electrically by applying a voltage pulse or a current pulse to the memory element.

One type of resistive memory is phase change memory. Phase change memory uses a phase change material in the resistive memory element. The phase change material exhibits at least two different states. The states of the phase change material may be referred to as the amorphous state and the crystalline state, where the amorphous state involves a more disordered atomic structure and the crystalline state involves a more ordered lattice. The amorphous state usually exhibits higher resistivity than the crystalline state. Also, some phase change materials exhibit multiple crystalline states, e.g. a face-centered cubic (FCC) state and a hexagonal closest packing (HCP) state, which have different resistivities and may be used to store bits of data. In the following description, the amorphous state generally refers to the state having the higher resistivity and the crystalline state generally refers to the state having the lower resistivity.

Phase changes in the phase change materials may be induced reversibly. In this way, the memory may change from the amorphous state to the crystalline state and from the crystalline state to the amorphous state in response to temperature changes. The temperature changes of the phase change material may be achieved by driving current through the phase change material itself or by driving current through a resistive heater adjacent the phase change material. With both of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The temperature in the phase change material in each memory cell generally corresponds to the applied level of current and/or voltage to achieve the heating.

To achieve higher density phase change memories, a phase change memory cell can store multiple bits of data. Multi-bit storage in a phase change memory cell can be achieved by programming the phase change material to have intermediate resistance values or states, where the multi-bit or multilevel phase change memory cell can be written to more than two states. If the phase change memory cell is programmed to one of three different resistance levels, 1.5 bits of data per cell can be stored. If the phase change memory cell is programmed to one of four different resistance levels, two bits of data per cell can be stored, and so on. To program a phase change memory cell to an intermediate resistance value, the amount of crystalline material coexisting with amorphous material and hence the cell resistance is controlled via a suitable write strategy.

A lot of data has limited read access: e.g., read once, twice... Other limitations than the number of read cycles are a limited read on the storage medium depending on the actual date and time or depending on the time elapsed since first read operation. In addition models like pay per read might be used in the near future. Up to now, storage media for that purpose might be compact disks (CDs) or digital versatile disks (DVDs). Non-volatile memories can be used as media to carry or sell data. Implementing these features in non-volatile memories gives much more secure systems than other hardware or even software solutions.

For these and other reasons, there is a need for the present invention.

### Summary

One embodiment provides an integrated circuit. The integrated circuit includes a memory with an array of memory cells, each memory cell comprising a non-volatile memory element, and a limited read circuit communicatively coupled to the array of memory cells.

### Brief Description of the Drawings

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description. The elements of the drawings are not necessarily to scale relative to each other. Like reference numerals designate corresponding similar parts.
Figure 1 is a block diagram illustrating one embodiment of a system.
Figure 2 is a diagram illustrating one embodiment of a memory device.
Figure 3 is a diagram illustrating a read pulse.
Figure 4a is a diagram illustrating one embodiment of a read pulse.
Figure 4b is a diagram illustrating another embodiment of a read pulse.
Figure 5a is a diagram illustrating one embodiment of a read pulse.
Figure 5b is a diagram illustrating another embodiment of a read pulse.
Figure 6a is a block diagram illustrating one embodiment of a method for reading and writing a memory.
Figure 6b is a block diagram illustrating one embodiment of a method for reading and writing a memory.
Figure 6c is a block diagram illustrating one embodiment of a method for reading and writing a memory.
Figure 7 is a block diagram illustrating another embodiment of a system.
Figure 8 is a block diagram illustrating another embodiment of a system.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

It is to be understood that the features of the various embodiments described herein may be combined with each other, unless specifically noted otherwise.

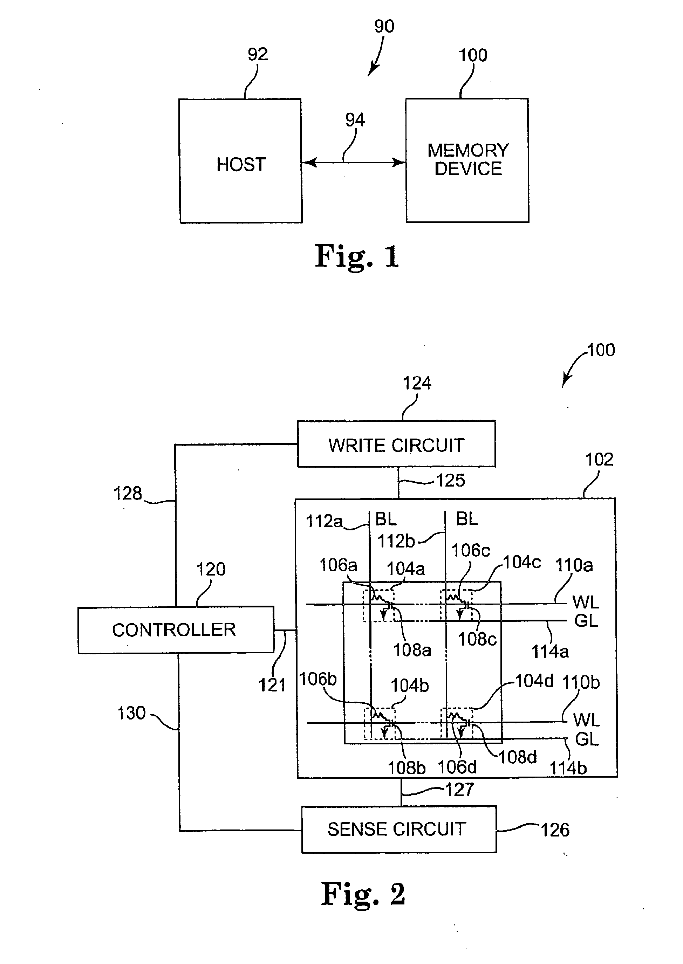

Figure 1 is a block diagram illustrating one embodiment of a system 90. System 90 includes a host 92 and a memory device 100. Host 92 is communicatively coupled to memory device 100 through communication link 94. Host 92 includes a computer. (e.g., desktop, laptop, handheld), portable electronic device (e.g., cellular phone, personal digital assistant (PDA), MP3 player, video player, digital camera), or any other suitable device that uses memory. Memory device 100 provides memory for host 92. In one embodiment, memory device 100 includes a resistivity changing memory device or a phase change memory device.

Memory device 100 is configured to provide a limited read function. In one embodiment, memory device 100 is configured to be read once. In other embodiments, memory device 100 can be read twice, three times, ... In other embodiments, memory device 100 are timed read depending on a timing signal or on a timing signal and a timing signal for a first read operation on the memory device 100. In one embodiment, the timing signal is provided externally to memory device 100. In another embodiment, the timing signal is provided internally.

Figure 2 is a diagram illustrating one embodiment of memory device 100. In one embodiment, memory device 100 is an integrated circuit or part of an integrated circuit. Memory device 100 includes a write circuit 124, a controller 120, a memory array 102, and a sense circuit 126. Memory array 102 includes a plurality of resistivity changing memory cells 104a-104d (collectively referred to as resistive memory cells 104), a plurality of bit lines (BLs) 112a-112b (collectively referred to as bit lines 112), a plurality of word lines (WLs) 1 10a-110b (collectively referred to as word lines 110), and a plurality of ground lines (GLs) 114a-114b (collectively referred to as ground lines 114). In one embodiment, resistivity changing memory cells 104 are phase change memory cells. In other embodiments, resistivity changing memory cells 104 are another suitable type of resistivity changing memory cells, such as magnetic memory cells.

As used herein, the term "electrically coupled" is not meant to mean that the elements must be directly coupled together and intervening elements may be provided between the "electrically coupled" elements.

Memory array 102 is electrically coupled to write circuit 124 through signal path 125, to controller 120 through signal path 121, and to sense circuit 126 through signal path 127. Controller 120 is electrically coupled to write circuit 124 through signal path 128 and to sense circuit 126 through signal path 130. Each phase change memory cell 104 is electrically coupled to a word line 110 and a bit line 112. Phase change memory cell 104a is electrically coupled to bit line 112a and word line 110a, and phase change memory cell 104b is electrically coupled to bit line 112a and word line 110b. Phase change memory cell 104c is electrically coupled to bit line 112b and word line 110a, and phase change memory cell 104d is electrically coupled to bit line 112b and word line 110b.

Each phase change memory cell 104 is electrically coupled to a word line 110, a bit line 112, and a ground line 114. For example, phase change memory cell 104a is electrically coupled to bit line 112a, word line 110a, and ground line 114a, and phase change memory cell 104b is electrically coupled to bit line 112a, word line 110b, and ground line 114b. Phase change memory cell 104c is electrically coupled to bit line 112b, word line 110a, and ground line 114a, and phase change memory cell 104d is electrically coupled to bit line 112b, word line 110b, and ground line 114b.

Each phase change memory cell 104 includes a phase change memory element 106 and a select device 108. While select device 108 is a field-effect transistor (FET) in the illustrated embodiment, the select device 108 can be other suitable devices such as a bipolar transistor or a 3D transistor structure. In other embodiments, a diode-like structure may be used in place of transistor 108. In this case, a diode and phase change element 106 is coupled in series between each cross point of word lines 110 and bit lines 112.

Phase change memory cell 104a includes phase change memory element 106a and transistor 108a. One side of phase change memory element 106a is electrically coupled to bit line 112a and the other side of phase change memory element 106a is electrically coupled to one side of the source-drain path of transistor 108a. The other side of the source-drain path of transistor 108a is electrically coupled to ground line 114a. The gate of transistor 108a is electrically coupled to word line 110a.

Phase change memory cell 104b includes phase change memory element 106b and transistor 108b. One side of phase change memory element 106b is electrically coupled to bit line 112a and the other side of phase change memory element 106b is electrically coupled to one side of the source-drain path of transistor 108b. The other side of the source-drain path of transistor 108b is electrically coupled to ground line 114b. The gate of transistor 108b is electrically coupled to word line 110b.

Phase change memory cell 104c includes phase change memory element 106c and transistor 108c. One side of phase change memory element 106c is electrically coupled to bit line 112b and the other side of phase change memory element 106c is electrically coupled to one side of the source-drain path of transistor 108c. The other side of the source-drain path of transistor 108c is electrically coupled to ground line 114a. The gate of transistor 108c is electrically coupled to word line 110a.

Phase change memory cell 104d includes phase change memory element 106d and transistor 108d. One side of phase change memory element 106d is electrically coupled to bit line 112b and the other side of phase change memory element 106d is electrically coupled to one side of the source-drain path of transistor 108d. The other side of the source-drain path of transistor 108d is electrically coupled to ground line 114b. The gate of transistor 108d is electrically coupled to word line 110b.

In one embodiment, each resistivity changing memory element 106 is a phase change memory element that comprises a phase change material that may be made up of a variety of materials. Generally, chalcogenide alloys that contain one or more elements from Group VI of the periodic table are useful as such materials. In one embodiment, the phase change material is made up of a chalcogenide compound material, such as GeSbTe, SbTe, GeTe, or AgInSbTe. In one embodiment, the phase change material is chalcogen free, such as GeSb, GaSb, InSb, or GeGaInSb. In other embodiments, the phase change material is be made up of any suitable material including one or more of the elements Ge, Sb, Te, Ga, As, In, Se, and S.

Each phase change memory element may be changed from an amorphous state to a crystalline state or from a crystalline state to an amorphous state under the influence of temperature change. The amount of crystalline material coexisting with amorphous material in the phase change material of one of the phase change memory elements thereby defines two or more states for storing data within memory device 100. In the amorphous state, a phase change material exhibits significantly higher resistivity than in the crystalline state. Therefore, the two or more states of the phase change memory elements differ in their electrical resistivity. In one embodiment, the two or more states are two states and a binary system is used, wherein the two states are assigned bit values of "0" and "1". In another embodiment, the two or more states are three states and a ternary system is used, wherein the three states are assigned bit values of "0", "1", and "2". In another embodiment, the two or more states are four states that are assigned multi-bit values, such as "00", "01", "10", and "11". In other embodiments, the two or more states are another suitable number of states in the phase change material of a phase change memory element

Controller 120 includes a microprocessor, microcontroller, or other suitable logic circuitry for controlling the operation of memory device 100. Controller 120 controls read and write operations of memory device 100 including the application of control and data signals to memory array 102 through write circuit 124 and sense circuit 126. In one embodiment, write circuit 124 provides voltage pulses through signal path 125 and bit lines 112 to memory cells 104 to program the memory cells. In another embodiment, write circuit 124 provides current pulses through signal path 125 and bit lines 112 to memory cells 104 to program the memory cells.

In one embodiment, sense circuit 126 reads each of the two or more states of memory cells 104 through bit lines 112 and signal path 127. Controller 120 is configured to set or reset each of the two or more states of memory cells 104 through bit lines 112 and signal path 127 immediately after reading it enabled by write circuit 124. In another embodiment, sense circuit 126 reads each of the two or more states of memory cells 104 through bit lines 112 and signal path 127 and sets or resets each of the two or more states of memory cells 104 through bit lines 112 and signal path 127 immediately after reading it.

As used herein, the term "immediately" is not meant to mean that the operations like reading and setting or resetting must be following right after each other and intervening operations may be provided between the "immediate" operations.

In one embodiment, to read the resistance of one of the memory cells 104, sense circuit 126 provides current that flows through one of the memory cells 104. Sense circuit 126 then reads the voltage across that one of the memory cells 104. In another embodiment, sense circuit 126 provides voltage across one of the memory cells 104 and reads the current that flows through that one of the memory cells 104. In another embodiment, write circuit 124 provides voltage across one of the memory cells 104 and sense circuit 126 reads the current that flows through that one of the memory cells 104. In another embodiment, write circuit 124 provides current that flows through one of the memory cells 104 and sense circuit 126 reads the voltage across that one of the memory cells 104.

During a "set" operation of phase change memory cell 104a, a set current or voltage pulse is selectively enabled by write circuit 124 and sent through bit line 112a to phase change memory element 106a thereby heating phase change memory element 106a above its crystallization temperature (but usually below its melting temperature). In this way, phase change memory element 106a reaches its crystalline state or a partially crystalline and partially amorphous state during this set operation.

During a "reset" operation of phase change memory cell 104a, a reset current or voltage pulse is selectively enabled by write circuit 124 and sent through bit line 112a to phase change memory element 106a. The reset current or voltage quickly heats phase change memory element 106a above its melting temperature. After the current or voltage pulse is turned off, phase change memory element 106a quickly quench cools into the amorphous state or a partially amorphous and partially crystalline state.

Phase change memory cells 104b-1 04d and other phase change memory cells 104 in memory array 102 are set and reset similarly to phase change memory cell 104a using a similar current or voltage pulse. In other embodiments, for other types of resistive memory cells, write circuit 124 provides suitable programming pulses to program the resistivity changing memory cells 104 to the desired state.

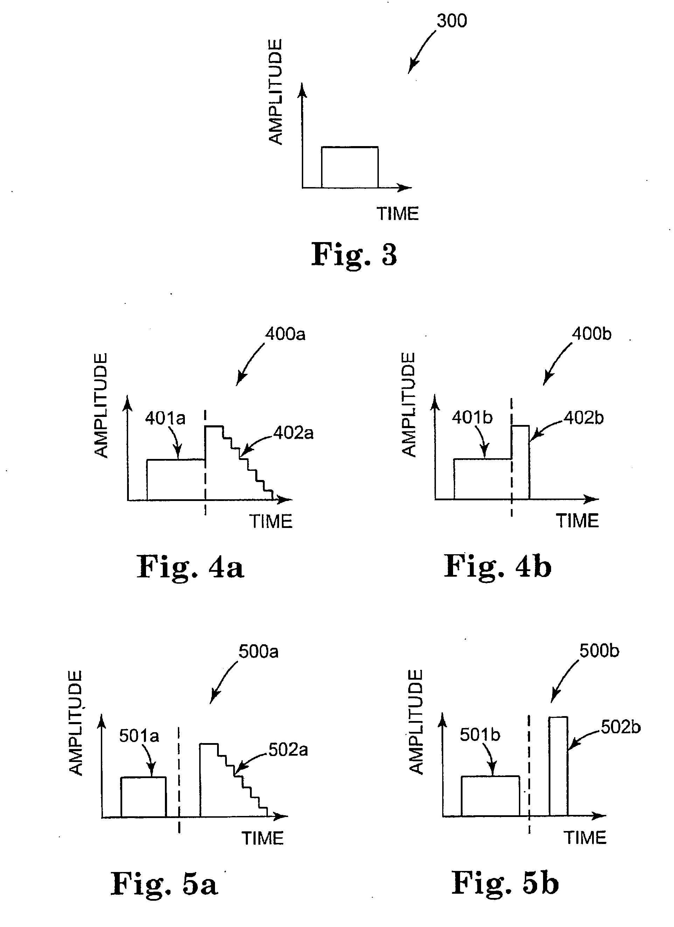

Figure 3 is a diagram illustrating a read pulse 300. Read pulse 300 is provided by sense circuit 126 to reads each of two or more states of memory cells 104 through bit lines 112 and signal path 127. Read pulse 300 provides current or voltage signals. Read pulse 300 is configured not to erase data stored in memory cells 104.

Figure 4a is a diagram illustrating one embodiment of a limited read pulse 400a. Limited read pulse 400a is provided by sense circuit 126 to read each of two or more states of memory cells 104 through bit lines 112 and signal path 127 and to set or reset memory cells 104 immediately after reading it. In one embodiment, limited read pulse 400a provides a current signal. In another embodiment, limited read pulse 400a provides a voltage signal. Limited read pulse 400a is configured to read data stored in memory cells 104 and to set or reset data stored in memory cells 104 immediately after reading it.

Sub-pulse 401a is configured to read data stored in memory cells 104. The amplitude of sub-pulse 401a is chosen not to erase data stored in memory cells 104. Sub-pulse 401a is configured not to change the state of the phase change material of memory cells 104. Figure 4a illustrates sub-pulse 40 1 a with a square shape or single burst. In other embodiments, sub-pulse 401a has any other suitable shape for read data stored in memory cells 104.

Sub-pulse 402a is configured to set or reset memory cells 104 to erase data stored in memory cells 104. In one embodiment, sub-pulse 402a has a step-like shape. In other embodiments, sub-pulse 402b has any suitable shapes for setting or resetting data stored in memory cells 104. Sub-pulse 402a follows immediately after sub-pulse 401 a. Data stored in memory cells 104 can only be read with erasing of the data stored in memory cells 104.

Figure 4b is a diagram illustrating another embodiment of a limited read pulse 400b. Limited read pulse 400b differs from the embodiment illustrated in Figure 4a in the shape of the set or reset sub-pulse 402.

Figure 5a is a diagram illustrating one embodiment of a limited read pulse 500a. Limited read pulse 500a is configured to read data stored in memory cells 104 and to erase data stored in memory cells 104 immediately after reading it by setting or resetting memory cells 104. Sub-pulse 501a is configured to read data stored in memory cells 104. Sub-pulse 502a is configured to erase data stored in memory cells 104. Sub-pulse 502a follows immediately after sub-pulse 501a. In one embodiment, a pre-determined time interval is between sub-pulse 502a and 502b. In another embodiment, sub-pulse 502a and 502b are timed externally. Data stored in memory cells 104 can only be read with a set or reset of memory cells 104.

In one embodiment, both sub-pulses 501a-502a are provided by sense circuit 126. In another embodiment, read sub-pulse 501 a is provided by sense circuit 126 and set or reset sub-pulse 502a is provided by write circuit 124. For every read on memory cells 104, controller 120 is only configured to read memory cells 104 with sub-pulse 5 01 a provided by sense circuit 126 and to set or reset memory cells 104 with sub-pulse 502a provided by write circuit 124. Data stored in memory cells 104 can only be read with an erase of data stored in memory cells 104.

In one embodiment, sub-pulse 501a provides a current signal. In another embodiment, sub-pulse 501 a provides a voltage signal. In one embodiment, erase pulse 502a provides a current signal. In another embodiment, erase pulse 502a provides a voltage signal.

Figure 5b is a diagram illustrating another embodiment of a limited read pulse 500b. Limited read pulse 500b is configured to read data stored in memory cells 104 and to erase data stored in memory cells 104 immediately after reading it. Sub-pulse 501 b is configured to read data stored in memory cells 104. Sub-pulse 502b is configured to set or reset memory cells 104. Sub-pulse 502b follows immediately after sub-pulse 501b. The read pulse 500b differs from the embodiment illustrated in Figure 5a in the shape of the reset sub-pulse 502. In other embodiments, sub-pulse 502b has any suitable shapes for setting or resetting memory cells 104.

In one embodiment, sub-pulse 501b provides a current signal. In another embodiment, sub-pulse 501b provides a voltage signal. In one embodiment, erase pulse 502b provides a current signal. In another embodiment, erase pulse 502b provides a voltage signal.

In one embodiment, memory device 100 is configured to erase the data stored in memory cells 104 by a "set" operation. In another embodiment, memory device 100 is configured to erase the data stored in memory cells 104 by a "reset" operation.

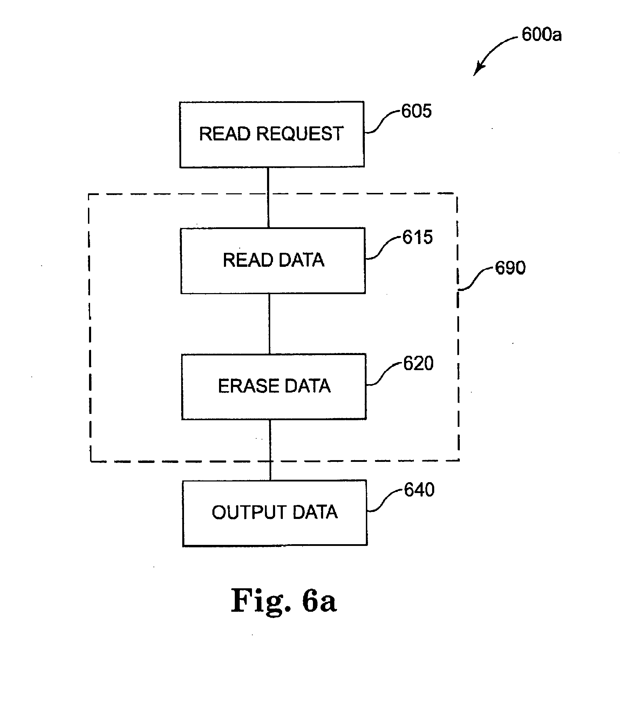

Figures 6a-6c are block diagrams illustrating embodiments of methods 600a-600c for reading and writing memory cells 104 in memory 100.

Figures 6a illustrates one embodiment of a method 600a for reading data in memory cells 104 in memory device 100 without any encryption or decryption of data. At 605, read request is from host 92 which includes a computer (e.g., desktop, laptop, handheld), portable electronic device (e.g., cellular phone, personal digital assistant (PDA), MP3 player, video player, digital camera), or any other suitable device that uses memory. Read request at 605 triggers a read of data at 615. At 620, erase of data is implemented immediately after reading data in memory cells 104. The sequence 690 formed by reading of data at 615 and erasing of data at 620 is as described in aforementioned embodiments. At 640, data is outputted to host 92. Read data from memory cells 104 in memory 100 is now transferred to host 92 and not stored any more in memory cells 104 in memory 100.

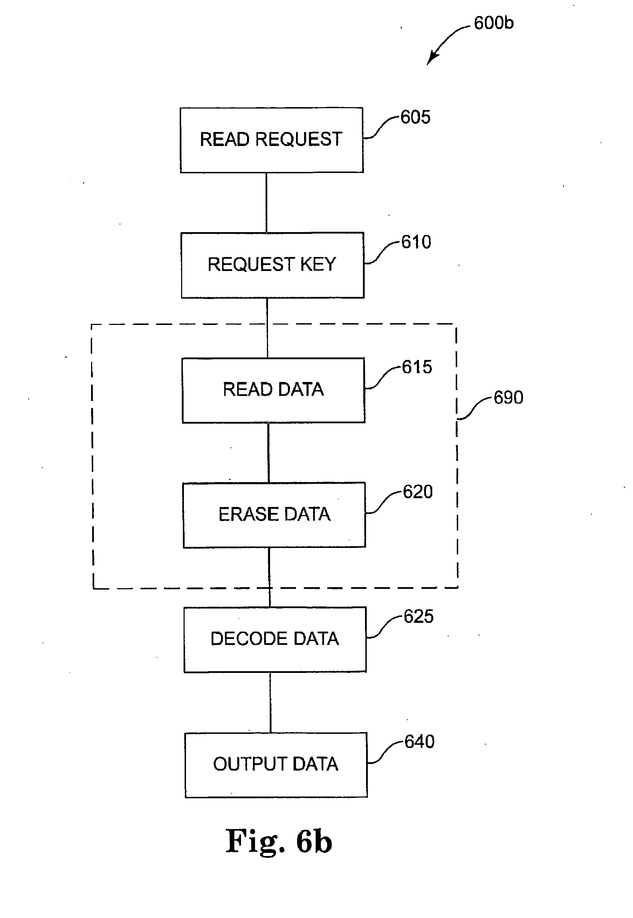

Figures 6b illustrates one embodiment of a method 600b for reading data in memory cells 104 in memory 100 with decryption of data. Read request at 605 is from host 92. At 610, read request triggers request for a key for decryption of data in memory cells 104 in memory 100. In one embodiment, the key for decryption of data in memory cells 104 in memory 100 is stored in memory 100. In another embodiment, the key for decryption is stored externally and is provided to memory 100. In one embodiment, the key is suited for symmetric key algorithms. In another embodiment, the key is suited for asymmetric key algorithms like public/private key algorithms. Read request at 605 triggers read of data at 615. Erase of data at 620 is implemented immediately after reading data in memory cells 104. The sequence 690 formed by reading of data at 615 and erasing of data at 620 is as described in aforementioned embodiments. Decoding of data 625 is performed with the key obtained at 610. At 640, data is outputted to host 92. Read data from memory cells 104 in memory 100 is now transferred to host 92 and not stored any more in memory cells 104 in memory 100.

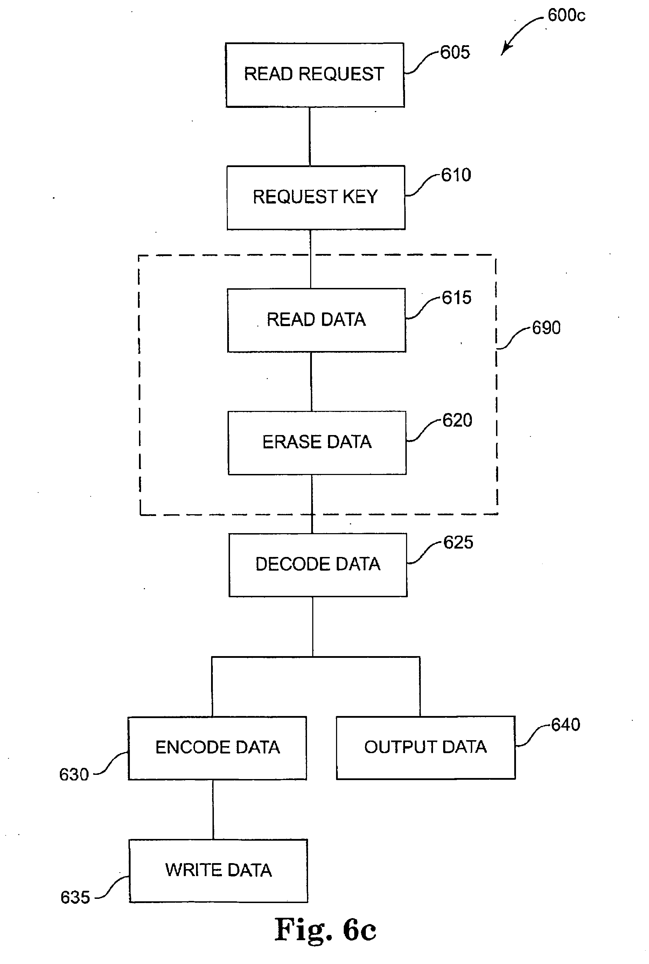

Figures 6c illustrates one embodiment of a method 600c for the incorporation of encryption and decryption for the data in memory cells 104. Read request at 605 is from host 92. At 610, read request triggers request for a key for decryption of data in memory cells 104 in memory 100. In one embodiment, the key for decryption of data in memory cells 104 in memory 100 is stored in memory 100. In another embodiment, the key for decryption is stored eternally and is provided to memory 100. Read request at 605 triggers a read of data at 615. Erase of data at 620 is implemented immediately after reading data in memory cells 104 in memory cells 104. The sequence 690 formed by reading of data at 615 and erasing of data at 620 is as described in aforementioned embodiments. Decoding of data at 625 is performed with the key from 610. Data is encrypted at 630 again with a newly generated key. The encrypted data is written back at 635 to memory cells 104 in memory 100. At 640, data is outputted to host 92. Read data from memory cells 104 in memory 100 is now transferred to host 92 and stored again in memory cells 104 in memory 100 with a newly generated key.

The user can buy the newly generated key for another read of the data in memory 100. In one embodiment, buying the new key is via internet. Other embodiments include buying a key via telephone, mobile phone, retail shop, or any other suited buying platform. Method 600c ensures "pay-per-read" of memory cells 104 in memory 100.

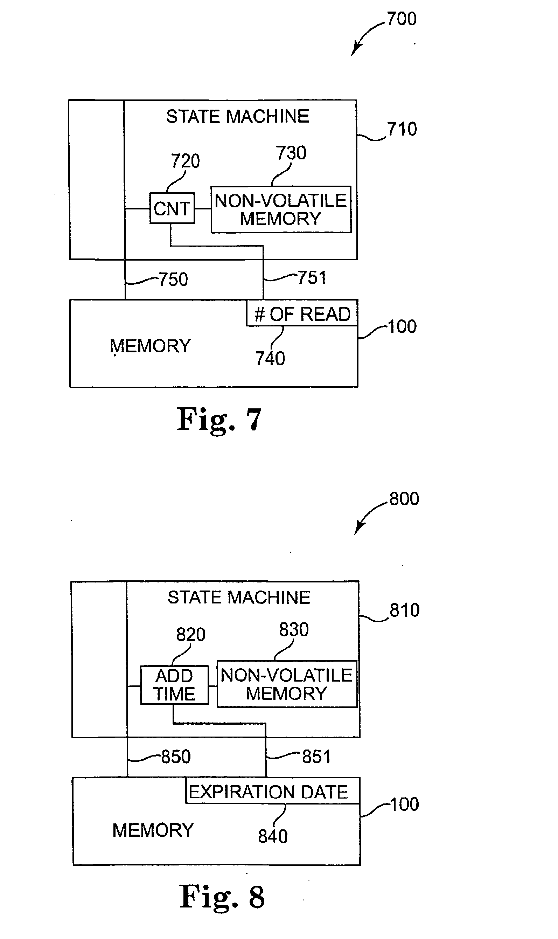

Figure 7 is a block diagram illustrating one embodiment of a system 700. A state machine 710 is communicatively coupled to memory 100 via data path 750 and cycle path 751. State machine 710 includes a counter CNT 720 including non-volatile memory 730 to save counter state. Counter CNT 720 is triggered for each read operation on memory 100. Counter CNT 720 reads the maximum number of read operations ("# of reads") 740 in memory 100 through cycle path 751. For counter CNT 720 having a smaller number of read operations than maximum number of reads 740, memory 100 is read without erasing. For counter CNT 720 greater than maximum number of reads 740, memory 100 is read and erased immediately after reading it according to one of the aforementioned embodiments. This ensures a predetermined number of read operations on memory 100. In one embodiment, state machine 710 and memory 100 are integrated on one die.

In one embodiment, memory 100 includes a sense circuit 126 configured to read memory cells 104, a read circuit configured to read memory cells 104 and to set or reset memory cells 104 immediately after reading it, and a controller 120. Controller 120 is configured to select between these circuits depending on a state signal. The state signal is provided by state machine 710.

Figure 8 is a block diagram illustrating another embodiment of a system 800. A state machine 810 is communicatively coupled to memory 100 via data path 850 and timing path 851. State machine 810 includes a time adder 820 which includes non-volatile memory 830 to save the state of the adder. Time adder 820 reads the expiration time of read operations ("expiration date") 840 in memory 100 through cycle path 851. In one embodiment, state machine 800 includes an input for system time. For each read operation on memory 100 it is checked whether the system time exceeds a predetermined expiration time 840. If the system time exceeds the predetermined expiration time 840, memory 100 is read and erased immediately after reading it according to one of the aforementioned embodiments. Otherwise, memory 100 is read without erasing. In one embodiment, predetermined expiration time 840 is integrated in memory 100. In one embodiment, the system time signal is protected by a key. In another embodiment, the system time is an internal timing signal. In one embodiment, state machine 810 and memory 100 are integrated on one die.

In another embodiment, expiration date 840 is a time interval. State machine 810 adds up times of usage of memory 100. In case the added time is greater than a predetermined time of usage 840, memory 100 is read and erased immediately after reading it according to one of the aforementioned embodiments. In case the added time is smaller than a predetermined time 840, memory 100 is read without any erasing. In one embodiment, the predetermined time of usage 840 is integrated in memory 100. In one embodiment, the system time signal is protected by a key. In another embodiment, the system time is an internal timing signal.

Memory device 100 is configured to provide a limited read function. In one embodiment, memory device 100 is configured to be read once. In other embodiments, memory device 100 can be read twice, three times, ... In other embodiments, memory device 100 are timed read depending on an external timing signal or on an external timing signal and a timing signal of a first read operations on the memory device 100.

While the specific embodiments described herein substantially focused on using phase change memory elements, the present invention can be applied to any suitable type of resistivity changing memory elements.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. An integrated circuit including a memory comprising:
an array of memory cells, each memory cell comprising a non-volatile memory element; and
a limited read circuit communicatively coupled to the array of memory cells.

2. The integrated circuit of claim 1, wherein the limited read circuit is configured to read the non-volatile memory element and to erase the non-volatile memory element immediately after reading it.

3. The integrated circuit of claim 1 or 2, wherein the limited read circuit is configured to provide a combined read/set or read/reset pulse.

4. The integrated circuit of claim 1 to 3, further comprising:
a sense circuit configured to read the non-volatile memory element; and
a read controller configured to select between the limited read circuit and the sense circuit depending on a state signal.

5. The integrated circuit of claim 4, wherein the read controller is integrated on the same die as the memory.

6. The integrated circuit of claim 4 or 5, wherein the read controller is configured to select between the limited read circuit and the sense circuit based on the number of read operations of the sense circuit.

7. The integrated circuit of claim 4 to 6, wherein the read controller is configured to select between the limited read circuit and the sense circuit based on a timing signal.

8. The integrated circuit of claim 1 to 7, wherein the non-volatile memory element comprises phase change material.

9. A method for reading a memory, the memory comprising an array of memory cells, each memory cell comprising a non-volatile memory element, the method comprising:
reading the non-volatile memory element; and
erasing the non-volatile memory element immediately after reading it.

10. The method of claim 9, wherein reading and resetting is with one combined read/set or read/reset pulse.

11. The method of claim 9 or 10, further comprising:
writing back the non-volatile memory element depending on a state signal.

12. The method of claim 11, wherein writing back the non-volatile memory element is based on the number of reads of the non-volatile memory element.

13. The method of claim 11, wherein writing back the non-volatile memory element is based on a timing signal.

14. The method of claim 9 to 13, further comprising:
decrypting the data read from the array of memory cells.

15. The method of claim 14, further comprising:
encrypting the data read from the array of memory cells; and
writing back the encrypted data to the array of memory cells.
